(19) Europäisches Patentamt
European Patent Office
Office européen des brevets

(11) **EP 1 101 279 B1**

(12) **EUROPÄISCHE PATENTSCHRIFT**

(45) Veröffentlichungstag und Bekanntmachung des Hinweises auf die Patenterteilung:
**09.10.2002 Patentblatt 2002/41**

(21) Anmeldenummer: **99948647.5**

(22) Anmeldetag: **09.07.1999**

(51) Int Cl.7: **H03F 1/30**, H03F 3/30

(86) Internationale Anmeldenummer:
**PCT/DE99/02129**

(87) Internationale Veröffentlichungsnummer:
**WO 00/007292 (10.02.2000 Gazette 2000/06)**

(54) **VERSTÄRKERAUSGANGSSTUFE**

AMPLIFIER OUTPUT STAGE

ETAGE DE SORTIE D'AMPLIFICATEUR

(84) Benannte Vertragsstaaten:
**AT DE FR GB IT**

(30) Priorität: **29.07.1998 DE 19834209**

(43) Veröffentlichungstag der Anmeldung:
**23.05.2001 Patentblatt 2001/21**

(73) Patentinhaber: **Infineon Technologies AG**
**81669 München (DE)**

(72) Erfinder: **LAASER, Peter**
**D-81669 München (DE)**

(74) Vertreter: **Reinhard - Skuhra - Weise & Partner**
**Friedrichstrasse 31**
**80801 München (DE)**

(56) Entgegenhaltungen:
**EP-A- 0 115 949          EP-A- 0 409 476**
**US-A- 5 285 168**

**Beschreibung**

Die Erfindung betrifft eine Verstärkerausgangsstufe nach dem Oberbegriff von Patentanspruch 1.

Die EP-0115949 A1 beschreibt einen Puffer-Schaltkreis mit einer hohen Impedanz. Der Puffer-Schaltkreis weist einen Hauptpuffer-Schaltkreisabschnitt auf, der aus einem Paar komplementärer Eingangstransistoren gebildet wird, deren Basisanschlüsse miteinander verbunden sind, sowie einen Zusatz-Schaltkreisabschnitt, der denselben Schaltkreisaufbau wie der Hauptpuffer-Schaltkreisabschnitt hat. Ein von dem Zusatz-Schaltkreisabschnitt erzeugtes Rückkoppelsignal wird dem Zusatz-Schaltkreisabschnitt und dem Hauptpuffer-Schaltkreisabschnitt zugeführt, damit das Ausgangssignal des Zusatzschaltkreisabschnitts einen vorbestimmten Wert einnimmt.

Bei Verstärkern, die hohe Ströme zum Treiben großer Lasten liefern müssen, wird üblicherweise als Endstufe ein komplementärer Emitter-/Sourcefolger im Gegentakt-AB-Betrieb eingesetzt (U.Tietze, Ch. Schenck, "Halbleiterschaltungstechnik", 9.Auflage, S. 516 bis 518 und S.521 bis 523). Bei dieser Betriebsart fließt durch die komplementären Endstufentränsistoren im nichtausgesteuerten Zustand des Verstärkers ständig ein Querstrom, der als Ruhestrom bezeichnet wird. Durch diesen Ruhestrom wird Leistung verbraucht, wodurch sich die Endstufentransistoren erwärmen. Als besonders problematisch erweist sich die Einstellung dieses temperaturabhängigen Ruhestroms auf einen niedrigen und konstanten Wert über einen großen Temperaturbereich, um den Stromverbrauch in der Endstufe zu minimieren und Verzerrungen zu vermeiden.

Aus IEEE Journal of Solid-State Circuits, Vol. 27, No. 4, Seiten 539 - 544, April 1992, "A CMOS Line Driver with 80-dB Linearity for ISDN Applications", H. Khorramabadi, ist ein Leitungstreiberverstärker für die ISDN U-Schnittstelle bekannt, bei dem ein sogenannter Error-Amplifier, der die Endstufe ansteuert, eingesetzt wird. Nachteilig ist bei einer solchen Anordnung, daß der Error-Amplifier direkt im Signalpfad des Verstärkers liegt und die Bandbreite des Verstärkers beeinflußt. Zudem hängt der Ruhestrom durch die Endstufentransistoren von der Offsetspannung der Error-Amplifier ab.

In IEEE Journal of Solid-State Circuits, Vol. 32, No. 32, Seiten 169 - 176, February 1997, "A Rail-to-Rail, Constant Gain, Buffered Op-Amp for Real Time Video Applications", L. Moldovan, H. H. Li und IEEE Journal of Solid-State Circuits, Vol. 29, No. 1, Seiten 63 - 65, January 1994, "Digital-Compatible High-Performance Operational Amplifier with Rail-to-Rail Input and Output Ranges", W.-CH. S. Wu, W. J. Helms, J. A. Kuhn, B. E. Byrkett sind Verstärker beschrieben, bei denen der Ruhestrom in der Endstufe von einer Eingangsstufe eingestellt wird und damit direkt von den Eingangssignalen und Strom- bzw. Spannungsschwankungen der Eingangsstufe abhängig ist.

In "Integrierte Schaltungen", A.Schlachetzki, W.v.Münch, Teubner 1978 ist auf Seite 144 in Bild 4.8 ein komplementärer Emitterfolger mit Ruhestromeinstellung dargestellt, bei dem der einzustellende Ruhestrom über als Dioden geschaltete Transistoren T3 und T4 in die Endstufentransistoren T1 und T2 gespiegelt wird. Bei dieser Anordnung kann jedoch der Ruhestrom nicht frei eingestellt werden.

Der Erfindung liegt daher die Aufgabe zugrunde, eine Verstärkerausgangsstufe anzugeben, die eine bessere Einstellbarkeit und Regelung des Ruhestroms in der Endstufe aufweist und bei der die Ruhestromregelung und -einstellung außerhalb des Signalpfades des Verstärkers liegt.

Diese Aufgabe wird durch eine Verstärkerausgangsstufe mit den Merkmalen von Patentanspruch 1 gelöst. Vorteilhafte Ausgestaltungen der Verstärkerausgangsstufe ergeben sich aus den jeweiligen Unteransprüchen.

Eine Ausführungsform der Verstärkerausgangsstufe umfaßt eine Vorstufe, eine Endstufe und eine Steuereinrichtung. Dabei wird der Ruhestrom durch die Transistoren der Endstufe durch die Vorstufe eingestellt, die mit der Steuereinrichtung verbunden ist. Die Vorstufe weist steuerbare Stromquellen auf, über die die Spannung an den Steueranschlüssen der Endstufentransistoren eingestellt wird. Diese Spannung legt den Ruhestrom durch die Endstufentransistoren fest. In der Steuereinrichtung wird ein Steuerstrom eingestellt, der zu dem Ruhestrom, der durch die Endstufentransistoren fließt, proportional ist. Daraus werden Steuerspannungen zur Einstellung der Stromquellen in der Vorstufe erzeugt, die wiederum den Ruhestrom in der Endstufe einstellen. Vorteilhafterweise liegt die Steuereinrichtung außerhalb des Signalpfades der Verstärkerausgangsstufe und begrenzt somit nicht die Bandbreite der Verstärkerausgangsstufe. In der Steuereinrichtung läßt sich zudem der Steuerstrom und damit der Ruhestrom auf einen beliebigen und genauen Wert einstellen.

In einer bevorzugten Ausführungsform der Erfindung weist die Vorstufe der Verstärkerausgangsstufe zwei Emitter- oder Sourcefolger-Schaltungen auf, die die Endstufe von einer Verstärkereingangsstufe, die die Verstärkerausgangsstufe ansteuert, abkoppelt. Vorteilhafterweise wird dadurch die Verstärkereingangsstufe entlastet, da die durch die Verstärkereingangsstufe angesteuerten Transistoren der Vorstufe eine geringere kapazizitive Last als die Transistoren der Endstufe für die Eingangsstufen darstellen. Jede Emitter- bzw. Sourcefolger-Schaltung weist eine steuerbare Stromquelle auf, die den Ruhestrom durch die Transistoren der Endstufe einstellt. Bei dieser Ausführungsform liegt im Signalpfad der Verstärkerausgangsstufe vorteilhafterweise nur ein Transistor, dessen Grenzfrequenz so hoch ist, daß die Bandbreite des Verstärkers nicht eingeschränkt wird.

Eine bevorzugte Ausführungsform der Steuereinrichtung weist eine erste und zweite Emitter- oder Sourcefolger-Schaltung auf, die jeweils die Emitter- bzw. Sourcefolger-Schaltungen der Vorstufe im nichtausgesteuerten Zustand nachbilden. Jede Emitter- bzw. Sourcefolger-Schaltung weist eine steuerbare Stromquelle auf. Die Eingänge der beiden Emitter- bzw. Sourcefolger-Schaltungen sind mit einer Spannung verbunden, die der Ausgangsspannung der Verstärkerausgangsstufe im Ruhezustand entspricht. Vorteilhafterweise gelten für die Emitter- bzw. Sourcefolger-Schaltungen der Vorstufe und der Steuereinrichtung ähnliche Betriebsbedingungen.

Die Endstufe weist in einer bevorzugten Ausführungsform einen ersten und zweiten Transistor auf, die im Gegentakt-AB-Betrieb betrieben werden. Von Vorteil ist dabei der gegenüber einer Endstufe im A-Betrieb niedrigere Klirrfaktor und der gegenüber einer Endstufe im B-Betrieb niedrigere Stromverbrauch.

Die Steuereinrichtung weist in einer bevorzugten Ausführungsform weiterhin einen ersten und zweiten Transistor und eine einstellbare Stromquelle auf. Die beiden Transistoren bilden dabei die beiden Transistoren der Endstufe nach und die Stromquelle speist in beide Transistoren einen Steuerstrom ein. Vorteilhafterweise ist der eingespeiste Steuerstrom einstellbar und proportional zum Ruhestrom in der Endstufe.

In einer bevorzugten Ausführungsform weist die Steuereinrichtung einen ersten und einen zweiten Spiegeltransistor auf, wobei der erste Spiegeltransistor den Strom durch den ersten Transistor und der zweite Spiegeltransistor den Strom durch den zweiten Transistor spiegelt. Vorteilhafterweise wird die Spannung an den Steueranschlüssen der Spiegeltransistoren zur Erzeugung der Steuerspannungen verwendet.

Besonders bevorzugt weist die Steuereinrichtung einen ersten und einen zweiten Steuertransistor auf, wobei die Steuertransistoren die Eingangsspannung an den Eingängen der Emitterfolger- oder Sourcefolger-Schaltungen an den ersten und zweiten Transistor übertragen. Somit weist die nachgebildete Endstufe ein Ruheausgangspotential auf, das vorteilhafterweise der Eingangsspannung an den Eingängen der Emitterfolger- oder Sourcefolger-Schaltungen entspricht und das Ruheausgangspotential läßt sich über die Eingangsspannung der Emitterfolger- oder Sourcefolger-Schaltungen einstellen.

In einer besonders bevorzugten Ausführungsform der Steuereinrichtung regelt ein erster und zweiter Operationsverstärker die in den Emitter- oder Sourcefolger-Schaltungen enthaltenen Stromquellen so, daß die Spannung am Ausgang des Operationsverstärker zur Einstellung der Stromquellen in der Vorstufe verwendet werden kann. Vorteilhafterweise ist dabei die Spannung nur durch die Offsetspannung von wenigen mV der Operationsverstärker und dem Verhältnis einiger Transistoren des Stromspiegels und der Endstufe abhängig. Diese Regelung der Steuerspannung hat den großen Vorteil, daß sie sehr genau ist und störende Einflüsse (OP-Offsetspannung, Transistorverhältnisse) einen vernachlässigbaren Einfluß auf die Steuerspannung haben.

In einer Ausführungsform der Erfindung, die besonders bevorzugt wird, ist die Verstärkerausgangsstufe in CMOS-Technologie ausgeführt. Der Vorteil dieser Ausführungsform liegt in der Integrationsfähigkeit mit weiteren Schaltungen in CMOS-Technologie sowie die weite Verbreitung von CMOS und den gegenüber anderen Technologien verhältnismäßig geringen Flächenbedarf.

Die Stromspiegel der Steuereinrichtung der Verstärkerausgangsstufe weisen in einer bevorzugten Ausführungsform Transistorverhältnisse auf, die den in die beiden Stromspiegel eingeprägten Strom fast vollständig durch jeweils einen der beiden Transistoren der Stromspiegel leiten. Dadurch stellt sich vorteilhafterweise an dem für beide Stromspiegeltransistoren gemeinsamen Steueranschluß ein Potential ein, das an die Steueranschlüsse der Transistoren der Endstufe angelegt einen definierten Ruhestrom durch die Transistoren der Endstufe ergibt.

Durch eine bevorzugte Dimensionierung der Verhältnisse von jeweils einem Transistor des Stromspiegels und eines Transistors der Endstufe kann der Ruhestrom durch den Transistor der Endstufe sehr genau eingestellt werden. Besonders bevorzugt wird dabei ein Verhältnis von 20, das sich durch die Dimensionierung der Transistoren sehr einfach einstellen läßt.

Die Integration der Verstärkerausgangsstufe auf einer integrierten Schaltung ist eine bevorzugte Ausführungsform. Von sehr großen Vorteil ist dabei die gute Einstellbarkeit der Verhältnisse der Transistorgeometrien.

In einer besonders bevorzugten Ausführungsform werden die Emitter- oder Sourcefolger-Schaltungen der Vorstufe und der Steuereinrichtung auf einer integrierten Schaltung örtlich nebeneinander gelegt. Dadurch verringert sich vorteilhafterweise der Einfluß von Prozeßschwankungen auf den Ruhestrom durch die Transistoren der Endstufe. Zudem haben Temperaturunterschiede zwischen den einzelnen Schaltungsteilen der Verstärkerausgangsstufe auf den Ruhestrom einen vernachlässigbaren Einfluß.

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigen

Figur 1    ein Schaltbild eines Ausführungsbeispiels des Verstärkers nach der Erfindung,

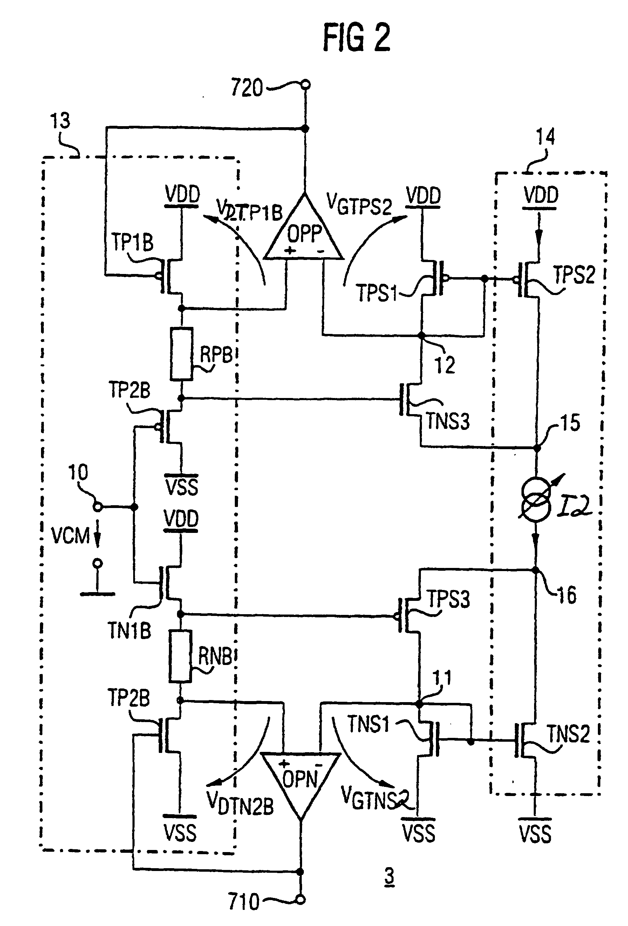

Figur 2    den Aufbau der Steuereinrichtung zur Einstellung des Ruhestroms in der Endstufe des Verstärkers nach der Erfindung.

Das im folgenden beschriebene Ausführungsbeispiel bezieht sich auf eine Ausführung der Erfindung in CMOS-Technologie.

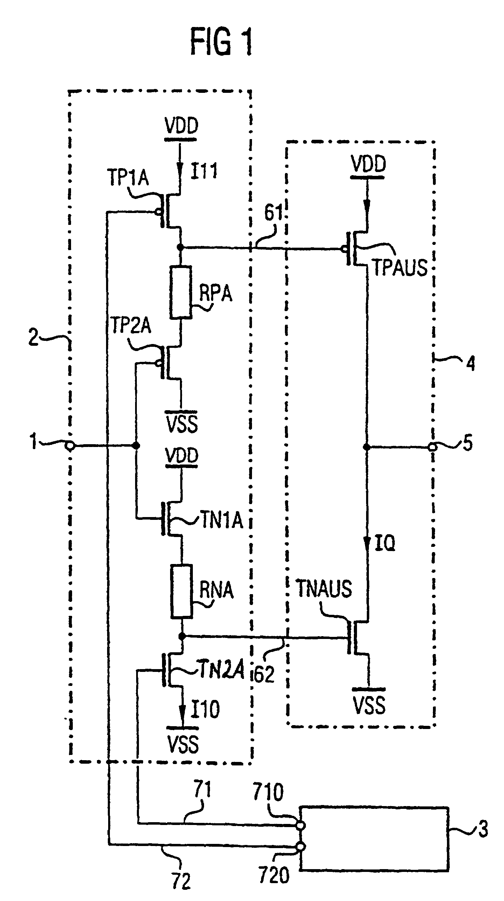

Gemäß Figur 1 umfaßt die Verstärkerausgangsstufe eine Vorstufe 2, eine Endstufe 4 und eine Steuereinrichtung 3, wobei die Vorstufe über zwei Leitungen 61 und 62 mit der Endstufe 4 und die Steuereinrichtung 3 über zwei Leitunge 71 und 72 mit der Vorstufe 2 verbunden ist. Über den Eingang 1 der Verstärkerausgangsstufe wird ein Signal eingespeist, das beispielsweise von einer Eingangsstufe mit hoher Verstärkung kommt. Am Ausgang 5 steht das verstärkte Signal zur Verfügung.

Die Vorstufe 2 besteht aus zwei Sourcefolger-Schaltungen.

Die erste Sourcefolger-Schaltung umfaßt einen ersten n-Kanal-MOSFET TN1A, dessen Drain-Anschluß mit einer ersten Spannungsversorgung VDD des Verstärkers verbunden ist und dessen Gate-Anschluß mit dem Eingang 1 der Verstärkerausgangsstufe verbunden ist. Der erste Transistor TN1A ist weiterhin über einen Widerstand RNA, der mit dem Source-Anschluß verbunden ist, mit dem Drain-Anschluß eines zweiten n-Kanal-MOSFET-Transistors TN2A verbunden, dessen Source-Anschluß mit einer zweiten Spannungsversorgung VSS verbunden ist.

Der zweite Sourcefolger ist spiegelbildlich zum ersten Sourcefolger in p-Kanal-Technologie aufgebaut und umfaßt einen ersten p-Kanal-MOSFET TP1A, dessen Drain-Anschluß mit der ersten Versorgungsspannung VDD des Verstärkers verbunden ist und dessen Source-Anschluß über einen Widerstand RPA mit dem Drain-Anschluß eines zweiten p-Kanal-MOSFET TP2A verbunden ist, dessen Source-Anschluß wiederum mit der zweiten Versorgungsspannung VSS verbunden ist. Der Gate-Anschluß des zweiten Transistor TP2A ist mit dem Eingang 1 der Verstärkerausgangsstufe verbunden.

Die Vorstufe 2 ist über zwei Leitungen 61 und 62 mit einer Endstufe 4 verbunden. Die Gate-Anschlüsse des zweiten Transistors TN2A des ersten Sourcefolgers und des ersten Transistors TP1A des zweiten Sourcefolgers sind über Leitungen 71 und 72 mit einer Steuereinrichtung 3 verbunden. Die Steuereinrichtung 3 steuert die Spannung, die an den Gate-Anschlüssen der Transistoren TN2A und TP1A über die Leitungen 71 und 72 anliegen, so daß die Transistoren TN2A und TP1A wie steuerbare Stromquellen wirken. Durch Veränderung dieser Spannungen werden die Ströme I10 und I11, die durch den ersten und zweiten Sourcefolger fließen, eingestellt. Dadurch können die über die Leitungen 61 und 62 an den Gate-Anschlüssen der Transistoren TPAUS und TNAUS der Endstufe 4 anliegenden Spannungen eingestellt werden. Durch Einstellen dieser Spannungen wird der Ruhestrom IQ, der durch die zwei Transistoren TPAUS und TNAUS der Endstufe fließt, eingestellt. Zusätzlich wird das Ruhepotential an einem Anschluß 5 der Endstufe 4 des Verstärkers eingestellt.

Die Endstufe 4 ist als komplementärer Sourcefolger oder Common-Source-Schaltung aufgebaut und umfaßt einen p-Kanal-MOSFET TPAUS, dessen Drain-Anschluß mit der ersten Versorgungsspannung VDD des Verstärkers verbunden ist, und einen n-Kanal-MOSFET TNAUS, dessen Source-Anschluß mit der zweiten Versorgungsspannung VSS verbunden ist. Der Source-Anschluß des Transistors TPAUS ist mit dem Drain-Anschluß des Transistors TNAUS verbunden und bildet den Ausgang 5 des Verstärkers. Wenn die Endstufe nicht ausgesteuert ist, fließt durch die beiden Transistoren TPAUS und TNAUS ein Querstrom IQ, der dem Ruhestrom der Endstufe entspricht. Die Endstufentransistoren sind für eine hohe Stromergiebigkeit dimensioniert und weisen dazu eine sehr große Weite des Kanals auf.

Die Steuereinrichtung 3 dient zur Einstellung und Regelung des Ruhestroms in der Endstufe 4 und weist zwei zur Vorstufe analoge Sourcefolgerschaltungen TN1B, RNB, TN2B und TP1B, RPB, TP2B, eine zur Endstufe analoge Endstufenschaltung TP2S, TN2S, zwei Operationsverstärker zur Ruhestromegelung OPP, OPN und zwei Spiegeltransistoren TPS1, TNS1 sowie zwei Steuertransistoren TNS3, TPS3 und eine einstellbare Stromquelle I2 auf.

Der erste Sourcefolger ist wie der erste Sourcefolger TN1A, RNA, TN2A der Vorstufe aufgebaut und umfaßt die n-Kanal-MOSFET's TN1B und TN2B, deren Source- und Drain-Anschluß über einen Widerstand RNB verbunden sind. Der Drain-Anschluß des Transistors TN1B ist mit der ersten Versorgungsspannung VDD des Verstärkers verbunden und der Source-Anschluß des Transistors TN2B ist mit der zweiten Versorgungsspannung VSS verbunden.

Der zweite Sourcefolger ist wie der zweite Sourcefolger TP1A, RPA, TP2A der Vorstufe aufgebaut und umfaßt die p-Kanal-MOSFET's TP1B und TP2B, deren Source- und Drain-Anschluß über einen Widerstand RPB miteinander verbunden sind. Der Drain-Anschluß des Transistors TP1B ist mit der ersten Versorgungsspannung VDD des Verstärkers verbunden und der Source-Anschluß des Transistors TP2B ist mit der zweiten Versorgungsspannung VSS verbunden.

Die Gate-Anschlüsse der Transistoren TN1B und TP2B sind mit einer Spannungsquelle 10 verbunden. Diese zwei Sourcefolger-Schaltungen 13 bilden die zwei Sourcefolger-Schaltungen der Vorstufe 2 in nichtausgesteuerten, d.h. Ruhezustand des Verstärkers nach. Die Spannung VCM der Spannungsquelle 10 ist dazu auf einen Wert innerhalb des durch die erste VDD und zweite VSS Versorgungsspannung definierten Bereichs festgelegt und entspricht dem Ruheausgangspotential der Verstärkerausgangsstufe. Vorzugsweise wird die Spannung VCM auf das Potential (VDD+VSS)/2 eingestellt, das sich am Ausgang 5 der Verstärkerausgangsstufe einstellen soll, wenn der Verstärker keine Signale verstärkt.

Der Steuertransistor TPS3 und TNS3 dient dazu, daß sich an einem Knoten 15 und 16 die Spannung VCM der Spannungsquelle 10 einstellt. Somit bilden TPS2, I2 und TNS2 die Endstufe 4 im Ruhezustand mit einem Ausgangspotential VCM und einem Ruhestrom I2 nach. Um ein Potential VCM an den Knoten 15 und 16 zu erhalten, sind die Steuertransistoren TPS3 und TNS3 so dimensioniert, daß sich die Einsatzspannungsverluste durch die Transistoren TP2B und TN1B aufheben.

Der durch die einstellbare Stromquelle eingeprägte Strom I2 wird nun proportional zu dem Ruhestrom IQ durch die Transistoren TPAUS und TNAUS der Endstufe 4 eingestellt:

$$12 = IQ/N.$$

Durch das Kanalweiten/-längen-Verhältnis W/L der MOSFET's TNS2 und TNAUS beziehungsweise TPS2 und TPAUS ergibt sich der Faktor N wie folgt:

$$W/L(TNS2) = W/L(TNAUS)/N$$

$$W/L(TPS2) = W/L(TPAUS)/N.$$

Um ein möglichst exaktes Verhältnis der Transistoren TNS2 und TNAUS beziehungsweise TPS2 und TPAUS zu erhalten, liegen diese Transistoren bei einer integrierten Schaltung örtlich möglichst nahe beieinander. Ungenauigkeiten aufgrund von Technologieschwankungen werden somit weitgehend vermieden.

Der Strom I2 wird jeweils in einen sehr kleinen Strom durch die Spiegeltransistoren TPS1 und TNS1 gespiegelt und an den Knoten 12 und 11 stellt sich eine Spannung VGTPS2 und VGTNS1 ein, die der Steuerspannung für die Transistoren TPAUS und TNAUS der Endstufe 4 entspricht, um durch die Transistoren der Endstufe einen Ruhestrom IQ zu erhalten. Dazu muß für das Kanalweiten/ -längenverhältnis W/L der MOSFET'S TNS1 und TNS2 sowie TPS1 und TPS2 gelten: W/L (TNS1) << W/L (TNS2) und W/L (TPS1) << W/L (TPS2).

Der erste Operationsverstärker OPP vergleicht die Spannung VGTPS2 mit der Spannung VDTP1B der nichtausgesteuerten Sourcefolger-Schaltung TP2B, RPB, TP1B und stellt über den an den Steueranschluß des Transistors TP1B rückgekoppelten Ausgang des Operationsverstärkers die Spannung VDTP1B wie die Spannung VGTPS2 ein. Die rückgekoppelte Ausgangsspannung wird über den Anschluß 720 zur Steuerung der Stromquelle TP1A der Vorstufe 2 verwendet. Auf diese Weise wird die Spannung VGTPS2 an den Transistor TPAUS der Endstufe 4 übertragen und stellt dort den gewünschten Ruhestrom IQ ein.

Der zweite Operationsverstärker OPN vergleicht die Spannung VGTNS2 mit der Spannung VDTN2B der nichtausgesteuerten Sourcefolger-Schaltung TN2B, RNB, TN1B und stellt über den an den Steueranschluß des Transistors TN2B rückgekoppelten Ausgang des Operationsverstärkers die Spannung VDTN2B wie die Spannung VGTNS2 ein. Die rückgekoppelte Ausgangsspannung wird über den Anschluß 710 zur Steuerung der Stromquelle TN2A der Vorstufe 2 verwendet. Auf diese Weise wird die Spannung VGTNS2 an den Transistor TNAUS der Endstufe 4 übertragen und stellt dort den gewünschten Ruhestrom IQ ein.

Bei niedrigen Versorgungsspannungen VDD und VSS oder großen Absolutwerten der Transistoreinsatzspannungen können die Widerstände RNA, RNB, RPA und RPB weggelassen werden.

Somit hängt die Einstellung des Ruhestroms IQ durch die Endtransistoren TPAUS und TNAUS ausschließlich von einer Offsetspannung der beiden Operationsverstärker OPN und OPP der Steuereinrichtung 3 und der Genauigkeit des Faktors N, der sich durch das Verhältnis der Transistoren TNAUS und TNS2 sowie TPAUS und TPS2 ergibt, ab.

Dadurch, daß die Offsetspannung der beiden Operationsverstärker im Verhältnis zur Spannung an den Gate-Anschlüssen der Transistoren TN2B und TN2A beziehungsweise TP1B und TP1A sehr gering ist (einige mV bzw. 1-2 Größenordnungen kleiner als die Gate-Spannungen), kann der Einfluß der Offsetspannungen auf die Genauigkeit der Ruhestromregelung vernachlässigt werden.

Temparaturschwankungen wirken sich ebenfalls nur in einem geringen Maß auf den Ruhestrom aus, da insbesondere bei einer Integration der Verstärkerausgangsstufe die Temperaturunterschiede der einzelnen Transistoren aufgrund der örtlichen Nähe zueinander vernachlässigbar sind.

Im Signalpfad des Verstärkers liegen neben den Transistoren der Eingangsstufe und der Endstufe lediglich die Transistoren TN1A und TP2A der Vorstufe 2. Der dadurch entstehende Pol in der Übertragungsfunktion des Verstärkers hat nur einen geringen Einfluß auf die Bandbreite des Verstärkers, da dieser Pol bei sehr hohen Frequenzen liegt.

Zur Erzielung eines niedrigen Stromverbrauchs des Verstärkers wird der Ruhestrom IQ durch die Transistoren der Endstufe so klein wie möglich eingestellt. Durch Einstellung des Stroms I2 der einstellbaren Stromquelle, der ein Bruchteil des Ruhestroms IQ ist, stellt man den Ruhestrom IQ in der Endstufe frei ein.

**Patentansprüche**

1. Verstärkerausgangsstufe, mit
   einer Vorstufe (2), die eine Vielzahl von einstellbaren Stromquellen (TN2A, TP1A) aufweist, über die ein Ruhestrom (IQ) in einer mit der Vorstufe (2) verbundenen Endstufe (4) einstellbar ist,

wobei in einer Steuereinrichtung (3) aus einem Steuerstrom (I2) Steuerspannungen (710, 720) entsprechend der Vielzahl von einstellbaren Stromquellen (TN2A, TP1A) der Vorstufe (2) erzeugt und geregelt werden und jede Steuerspannung (710, 720) genau eine der einstellbaren Stromquellen (TN2A, TP1A) in der Vorstufe (2) steuert, **dadurch gekennzeichnet,** **dass** der Steuerstrom (I2) in der Steuereinrichtung (3) proportional zu dem Ruhestrom (IQ) in der Endstufe (4) ist.

2. Verstärkerausgangsstufe nach Anspruch 1, **dadurch gekennzeichnet,** **dass** die Vorstufe (2) zwei Emitterfolger- oder Sourcefolger-Schaltungen (TP1A, RPA, TP2A; TN1A, RNA, TN2A) aufweist, wobei jede Emitterfolger- bzw. Sourcefolger-Schaltung genau eine der Vielzahl von einstellbaren Stromquellen (TP1A, TN2A) der Vorstufe (2) umfaßt.

3. Verstärkerausgangsstufe nach Anspruch 2, **dadurch gekennzeichnet,** **dass** die Steuereinrichtung (3) zwei Emitterfolger- oder Sourcefolger-Schaltungen (TN1B, RNB, TN2B; TP1B, RPB, TP2B) aufweist, wobei beide Emitterfolger- bzw. Sourcefolger-Schaltungen die zwei Emitter- bzw. Sourcefolger-Schaltungen (TN1A, RNA, TN2A; TP1A, RPA, TP2A) der Vorstufe (2) im nichtausgesteuerten Zustand nachbilden.

4. Verstärkerausgangsstufe nach einem der vorhergehenden Ansprüche, **dadurch gekennzeichnet,** **dass** die Endstufe (4) einen ersten (TPAUS) und zweiten (TNAUS) Transistor im Gegentakt-AB-Betrieb aufweist.

5. Verstärkerausgangsstufe nach Anspruch 4, **dadurch gekennzeichnet,** **dass** die Steuereinrichtung (3) einen ersten Transistor (TPS2) und einen zweiten (TNS2) Transistor und eine einstellbare Stromquelle (I2) aufweist, wobei der erste Transistor (TPS2) der Steuereinrichtung (3) den ersten Transistor (TPAUS) der Endstufe (4) und der zweite Transistor (TNS2) der Steuereinrichtung (3) den zweiten Transistor (TNAUS) der Endstufe (4) nachbildet und die einstellbare Stromquelle (IQ) einen Steuerstrom in die beiden Transistoren der Steuereinrichtung (3) einspeist.

6. Verstärkerausgangsstufe nach Anspruch 5, **dadurch gekennzeichnet,** **dass** die Steuereinrichtung (3) einen ersten Spiegeltransistor (TPS1) und einen zweiten Spiegeltransistor (TNS1) aufweist, wobei der erste Spiegeltransistor (TPS1) den Strom durch den ersten Transistor (TPS2) der Steuereinrichtung (3) und der zweite Spiegeltransistor (TNS1) den Strom durch den zweiten Transistor (TNS2) der Steuereinrichtung (3) spiegelt.

7. Verstärkerausgangsstufe nach Anspruch 6, **dadurch gekennzeichnet,** **dass** die Steuereinrichtung (3) einen ersten Steuertransistor (TNS3) und einen zweiten Steuertransistor (TPS3) aufweist, wobei der erste Steuertransistor (TNS3) den in den ersten Spiegeltransistor (TPS1) fließenden Strom einstellt und der zweite Steuertransistor (TPS3) den in den zweiten Spiegeltransistor (TNS1) fließenden Strom einstellt.

8. Verstärkerausgangsstufe nach Anspruch 3, 4, 5, 6 oder 7, **dadurch gekennzeichnet,** **dass** die Steuereinrichtung (3) einen ersten Regeloperationsverstärker (OPP) und einen zweiten Regel-Operationsverstärker (OPN) aufweist, wobei der erste Regel-Operationsverstärker (OPP) die Steuerspannung (720) der einstellbaren Stromquelle (TP1B) der ersten Emitter- oder Sourcefolger-Schaltung der Steuereinrichtung (3) regelt und der zweite Regel-Operationsverstärker (OPN) die Steuerspannung (710) der einstellbaren Stromquelle (TN2B) der zweiten Emitter- oder Sourcefolger-Schaltung der Steuereinrichtung (3) regelt.

9. Verstärkerausgangsstufe nach einem der vorhergehenden Ansprüche, **dadurch gekennzeichnet,** **dass** die Verstärkerausgangsstufe p-Kanal- und n-Kanal-MOSFET-Transistoren in CMOS-Technologie aufweist.

10. Verstärkerausgangsstufe nach einem der vorangehenden Ansprüche 5 bis 9, **dadurch gekennzeichnet,** **dass** der Steuerstrom (I2) in der Steuereinrichtung (3) ein Bruchteil (N) des durch die Transistoren ($TN_{aus}$, $TP_{aus}$) der Endstufe (4) fließende Ruhestroms (IQ) ist, wobei der Bruchteil (N) durch das Kanal-Weiten/Längenverhältnis $W/L_5$ des zweiten Transistors (TNS2) der Steuereinrichtung (3) und durch das Kanal-Weiten/Längenverhältnis $W/L_6$ des zweiten Transistors ($TN_{aus}$) der Endstufe (4) sowie durch das Kanal-Weiten/Längenverhältnis $W/L_7$ des ersten Transistors (TPS2) der Steuereinrichtung (3) und durch das Kanal-Weiten/Längenverhältnis $W/L_8$ des ersten Transistors ($TP_{aus}$) der Endstufe (4) bestimmt wird.

11. Verstärkerausgangsstufe nach einem der vorhergehenden Ansprüche,

**dadurch gekennzeichnet,**
**dass** die Verstärkerausgangsstufe als integrierte Schaltung ausgeführt ist.

12. Verstärkerausgangsstufe nach Anspruch 11,
**dadurch gekennzeichnet,**
**dass** die erste Emitterfolger- oder Sourcefolger-Schaltung (TN1A, TN2A) der Vorstufe (2) und die erste Emitterfolger- bzw. Sourcefolger-Schaltung (TN1B, TN2B) der Steuereinrichtung (3) sowie die zweite Emitterfolger- bzw. Sourcefolger-Schaltung (TP1A, TP2A) der Vorstufe (2) und die zweite Emitterfolger- bzw. Sourcefolger-Schaltung (TP1B, TP2B) der Steuereinrichtung (3) auf einer integrierten Schaltung unmittelbar nebeneinander liegen.

**Claims**

1. Amplifier output stage having
a preliminary stage (2), which has a multiplicity of adjustable current stages (TN2A, TP1A), by means of which a quiescent current (IQ) can be set in a final stage (4) connected to the preliminary stage (2),
in which case, in a control device (3), from a control current (I2), control voltages (710, 720) are generated and regulated in accordance with the multiplicity of adjustable current sources (TN2A, TP1A) of the preliminary stage (2), and each control voltage (710, 720) controls precisely one of the adjustable current sources (TN2A, TP1A) in the preliminary stage (2),
**characterized**
**in that** the control current (I2) in the control device (3) is proportional to the quiescent current (IQ) in the output stage (4).

2. Amplifier output stage according to Claim 1,
**characterized in that**
the preliminary stage (2) has two emitter follower or source follower circuits (TP1A, RPA, TP2A; TN1A, RNA, TN2A), each emitter follower or source follower circuit comprising precisely one of the multiplicity of adjustable current sources (TP1A, TN2A) of the preliminary stage (2).

3. Amplifier output stage according to Claim 2,
**characterized in that**
the control device (3) has two emitter follower or source follower circuits (TN1B, RNB, TN2B; TP1B, RPB, TP2B), the two emitter follower or source follower circuits simulating the two emitter or source follower circuits (TN1A, RNA, TN2A; TP1A, RPA, TP2A) of the preliminary stage (2) in the non-driven state.

4. Amplifier output stage according to one of the preceding claims,
**characterized in that**
the final stage (4) has a first (TPAUS) and second (TNAUS) transistor in push-pull class AB operation.

5. Amplifier output stage according to Claim 4,
**characterized in that**
the control device (3) has a first transistor (TPS2) and a second transistor (TNS2) and an adjustable current source (I2), the first transistor (TPS2) of the control device (3) simulating the first transistor (TPAUS) of the final stage (4) and the second transistor (TNS2) of the control device (3) simulating the second transistor (TNAUS) of the final stage (4) and the adjustable current source (IQ) feeding a control current into the two transistors of the control device (3).

6. Amplifier output stage according to Claim 5,
**characterized in that**
the control device (3) has a first mirror transistor (TPS1) and a second mirror transistor (TNS1), the first mirror transistor (TPS1) mirroring the current through the first transistor (TPS2) of the control device (3) and the second mirror transistor (TNS1) mirroring the current through the second transistor (TNS2) of the control device (3).

7. Amplifier output stage according to Claim 6,
**characterized in that**
the control device (3) has a first control transistor (TNS3) and a second control transistor (TPS3), the first control transistor (TNS3) setting the current which flows into the first mirror transistor (TPS1), and the second control transistor (TPS3) setting the current which flows into the second mirror transistor (TNS1).

8. Amplifier output stage according to Claim 3, 4, 5, 6 or 7,
**characterized in that**
the control device (3) has a first regulating operational amplifier (OPP) and a second regulating operational amplifier (OPN), the first regulating operational amplifier (OPP) regulating the control voltage (720) of the adjustable current source (TP1B) of the first emitter or source follower circuit of the control device (3) and the second regulating operational amplifier (OPN) regulating the control voltage (710) of the adjustable current source (TN2B) of the second emitter or source follower circuit of the control device (3).

9. Amplifier output stage according to one of the preceding claims,
**characterized in that**
the amplifier output stage has p-channel and n-channel MOSFET transistors using CMOS technology.

**10.** Amplifier output stage according to one of the preceding claims 5 to 9,
**characterized in that**
the control current (12) in the control device (3) is a fraction (N) of the quiescent current (IQ) flowing through the transistors ($TN_{aus}$, $TP_{aus}$) of the final stage (4), the fraction (N) being determined by the channel width/length ratio $W/L_5$ of the second transistor (TNS2) of the control device (3) and by the channel width/length ratio $WL_6$ of the second transistor ($TN_{aus}$) of the final stage (4) and also by the channel width/length ratio $W/L_7$ of the first transistor (TPS2) of the control device (3) and
by the channel width/length ratio $W/L_8$ of the first transistor ($TP_{aus}$) of the final stage (4).

**11.** Amplifier output stage according to one of the preceding claims,
**characterized in that**
the amplifier output stage is embodied as an integrated circuit.

**12.** Amplifier output stage according to Claim 11,
**characterized in that**
the first emitter follower or source follower circuit (TN1A, TN2A) of the preliminary stage (2) and the first emitter follower or source follower circuit (TN1B, TN2B) of the control device (3) and also the second emitter follower or source follower circuit (TP1A, TP2A) of the preliminary stage (2) and the second emitter follower or source follower circuit (TP1B, TP2B) of the control device (3) lie directly next to one another on an integrated circuit.

**Revendications**

**1.** Etage de sortie d'amplificateur, comprenant :

un étage d'entrée (2), qui présente une pluralité de sources de courant réglables (TN2A, TP1A), par lesquelles un courant de repos (IQ) peut être réglé dans un étage de sortie (4) connecté à l'étage d'entrée (2),

dans lequel, dans un dispositif de commande (3), à partir d'un courant de commande (12) sont produites et réglées des tensions de commande (710, 720) correspondant à la pluralité de sources de courant réglables (TN2A, TP1A) de l'étage d'entrée (2) et chaque tension de commande (710, 720) commande exactement l'une des sources de courant réglables (TN2A, TP1A) de l'étage d'entrée (2),
**caractérisé en ce que** le courant de commande (12) du dispositif de commande (3) est proportionnel au courant de repos (IQ) de l'étage de sortie (4).

**2.** Etage de sortie d'amplificateur selon la revendication 1,
**caractérisé en ce que** l'étage d'entrée (2) présente deux circuits suiveurs d'émetteur, respectivement suiveurs de source (TP1A, RPA, TP2A; TN1A, RNA, TN2A), chaque circuit suiveur d'émetteur, respectivement suiveur de source comprenant exactement une de la pluralité de sources de courant réglables (TP1A, TN2A) de l'étage d'entrée (2).

**3.** Etage de sortie d'amplificateur selon la revendication 2,
**caractérisé en ce que** le dispositif de commande (3) présente deux circuits suiveurs d'émetteur, respectivement suiveurs de source (TN1B, RNB, TN2B; TP1B, RPB, TP2B), les deux circuits suiveurs d'émetteur, respectivement suiveurs de source reproduisant les deux circuits suiveurs d'émetteur, respectivement suiveurs de source (TN1A, RNA, TN2A; TP1A, RPA, TP2A) de l'étage d'entrée (2) à l'état non réglé au maximum.

**4.** Etage de sortie d'amplificateur selon l'une quelconque des revendications précédentes,
**caractérisé en ce que** l'étage de sortie (4) présente un premier (TPAUS) et un second (TNAUS) transistors en exploitation symétrique AB.

**5.** Etage de sortie d'amplificateur selon la revendication 4,
**caractérisé en ce que** le dispositif de commande (3) présente un premier transistor (TPS2) et un second transistor (TNS2) ainsi qu'une source de courant réglable (12), le premier transistor (TPS2) du dispositif de commande (3) reproduisant le premier transistor (TPAUS) de l'étage de sortie (4) et le second transistor (TNS2) du dispositif de commande (3) reproduisant le second transistor (TNAUS) de l'étage de sortie (4), et la source de courant réglable (IQ) délivrant un courant de commande dans les deux transistors du dispositif de commande (3).

**6.** Etage de sortie d'amplificateur selon la revendication 5,
**caractérisé en ce que** le dispositif de commande (3) présente un premier transistor miroir (TPS1) et un second transistor miroir (TNS1), le premier transistor miroir (TPS1) reflétant le courant passant par le premier transistor (TPS2) du dispositif de commande (3) et le second transistor miroir (TNS1) reflétant le courant passant par le second transistor (TNS2) du dispositif de commande (3).

**7.** Etage de sortie d'amplificateur selon la revendication 6,
**caractérisé en ce que** le dispositif de commande (3) présente un premier transistor de commande (TNS3) et un second transistor de commande (TPS3), le premier transistor de commande (TNS3) réglant le courant s'écoulant dans le premier transistor miroir (TPS1) et le second transistor de commande (TPS3) réglant le courant s'écoulant dans le second transistor miroir (TNS1).

8. Etage de sortie d'amplificateur selon 1a revendication 3, 4, 5, 6 ou 7,
**caractérisé en ce que** le dispositif de commande (3) présente un premier amplificateur opérationnel de réglage (OPP) et un second amplificateur opérationnel de réglage (OPN), le premier amplificateur opérationnel de réglage (OPP) régulant la tension de commande (720) de la source de courant réglable (TP1B) du premier circuit suiveur d'émetteur, respectivement suiveur de source du dispositif de commande (3) et le second amplificateur opérationnel de réglage (OPN) régulant la tension de commande (710) de la source de courant réglable (TN2B) du second circuit suiveur d'émetteur, respectivement suiveur de source du dispositif de commande (3).

9. Etage de sortie d'amplificateur selon l'une quelconque des revendications précédentes,
**caractérisé en ce que** l'étage de sortie d'amplificateur présente des transistors MOSFET à canal p et à canal n en technologie CMOS.

10. Etage de sortie d'amplificateur selon l'une quelconque des revendications 5 à 9,
**caractérisé en ce que** le courant de commande (I2) du dispositif de commande (3) est une fraction (N) du courant de repos (IQ) s'écoulant à travers les transistors ($TN_{aus}$, $TP_{aus}$) de l'étage de sortie (4), dans lequel la fraction (N) est déterminée par le rapport de la largeur à la longueur de canal $W/L_5$ du second transistor (TNS2) du dispositif de commande (3) et par le rapport de la largeur à la longueur de canal $W/L_6$ du second transistor ($TN_{aus}$) de l'étage de sortie (4), ainsi que par le rapport de la largeur à la longueur de canal $W/L_7$ du premier transistor (TPS2) du dispositif de commande (3) et par le rapport de la largeur à la longueur de canal $W/L_8$ du premier transistor ($TP_{aus}$) de l'étage de sortie (4).

11. Etage de sortie d'amplificateur selon l'une quelconque des revendications précédentes,
**caractérisé en ce que** l'étage de sortie d'amplificateur se présente sous la forme d'un circuit intégré.

12. Etage de sortie d'amplificateur selon la revendication 11,
**caractérisé en ce que** le premier circuit suiveur d'émetteur, respectivement suiveur de source (TN1A, TN2A) de l'étage d'entrée (2) et le premier circuit suiveur d'émetteur, respectivement suiveur de source (TN1B, TN2B) du dispositif de commande (3) ainsi que le second circuit suiveur d'émetteur, respectivement suiveur de source (TP1A, TP2A) de l'étage d'entrée (2) et le second circuit suiveur d'émetteur, respectivement suiveur de source (TP1B, TP2B) du dispositif de commande (3) sont situés directement l'un à côté de l'autre sur un circuit intégré.

# FIG 1

# FIG 2